**Europäisches Patentamt**

**European Patent Office**

**Office européen des brevets**

(11) Numéro de publication: **0 155 278**

**B1**

(12) # FASCICULE DE BREVET EUROPÉEN

(45) Date de publication du fascicule du brevet:
**04.11.87**

(51) Int. Cl.⁴: **B 23 P 19/02 //**
**B23Q1/24**

(21) Numéro de dépôt: **84903048.1**

(22) Date de dépôt: **22.08.84**

(86) Numéro de dépôt international:
**PCT/CH 84/00132**

(87) Numéro de publication internationale:
**WO 85/01003 (14.03.85 Gazette 85/07)**

(54) **ROBOT D'ASSEMBLAGE PERMETTANT D'APPLIQUER UNE FORCE UNE PIÈCE.**

(30) Priorité: **26.08.83 CH 4691/83**

(43) Date de publication de la demande:
**25.09.85 Bulletin 85/39**

(45) Mention de la délivrance du brevet:
**04.11.87 Bulletin 87/45**

(84) Etats contractants désignés:
**AT BE CH DE FR GB IT LI LU NL SE**

(56) Documents cité:
**DE-B-1 133 964**
**DE-B-2 647 734**

(73) Titulaire: **COD INTER TECHNIQUES SA, 16, rue Albert Gos, CH- 1206 Genève (CH)**

(72) Inventeur: **HORVATH, Laszlo, S., 51, rte de Frontenex, CH- 1207 Genève (CH)**

(74) Mandataire: **Vuille, Roman, c/o KIRKER & Cie S.A. 14, rue du Mont- Blanc Case Postale 872, CH- 1211 Genève 1 (CH)**

EP 0 155 278 B1

## Description

La présente invention a pour objet un robot d'assemblage de pièces de type soit manipulateur, soit non manipulateur. Elle a plus précisément pour objet un robot comprenant au moins un support de pièces dans une aire d'assemblage et une tête portant l'outil d'assemblage et mobile en translation et/ou en rotation par rapport au support de pièces grâce à des supports de guidage. La tête est positionnée par des moteurs et porte de façon fixe ou coulissante un dispositif permettant d'appliquer l'outil sur une pièce avec une force déterminée.

De nos jours, l'emploi des robots industriels se diversifie toujours plus: de nouvelles branches de l'industrie introduisent progressivement de tels robots dans des domaines jusqu'alors inexploités; d'autre part, les tâches confiées à ces robots évoluent elles-mêmes pour devenir plus complexes, plus délicates ou nécessiter plus de précision par exemple.

Certains robots doivent accomplir des tâches requérant l'emploi d'une force mécanique parfois importante. Si les structures mobiles d'un robot sont légères afin de permettre une grande vitesse de déplacement, elles ne sont pas capables d'absorber la réaction à une force d'application à la pièce. Au niveau des robots dits non manipulateurs, par exemple les robots-portiques, ce problème n'a pour l'instant trouvé aucune solution. Il s'ensuit que nombre de manipulations échappent ainsi au domaine des robots-portiques et nécessitent l'emploi d'instruments annexes, voire des actions purement manuelles. Dans ce cas, l'invention permet de combler avantageusement une telle lacune. Pour atteindre ce but, le robot selon l'invention est doté des caractères définis dans la revendication 1.

Les dessins ci-joints illustrent, à titre purement indicatif, certaines des exécutions de robots selon la présente invention ou le détail de certaines desdites exécutions. Il convient de noter à ce propos que la présente invention n'est en aucun cas limitée aux différentes exécutions ainsi illustrées.

Figure 1 est une vue de profil représentant l'une des exécutions de l'invention.

Figure 2 est une coupe du dispositif permettant d'appliquer une force à l'outil.

Figure 3 représente en coupe une autre forme d'exécution du dispositif permettant d'appliquer une force à l'outil.

Figure 4 est une coupe verticale d'une forme, d'exécution préférée du robot selon l'invention.

Figure 5 est une vue en plan de la forme d'exécution du robot représenté à la fig. 4.

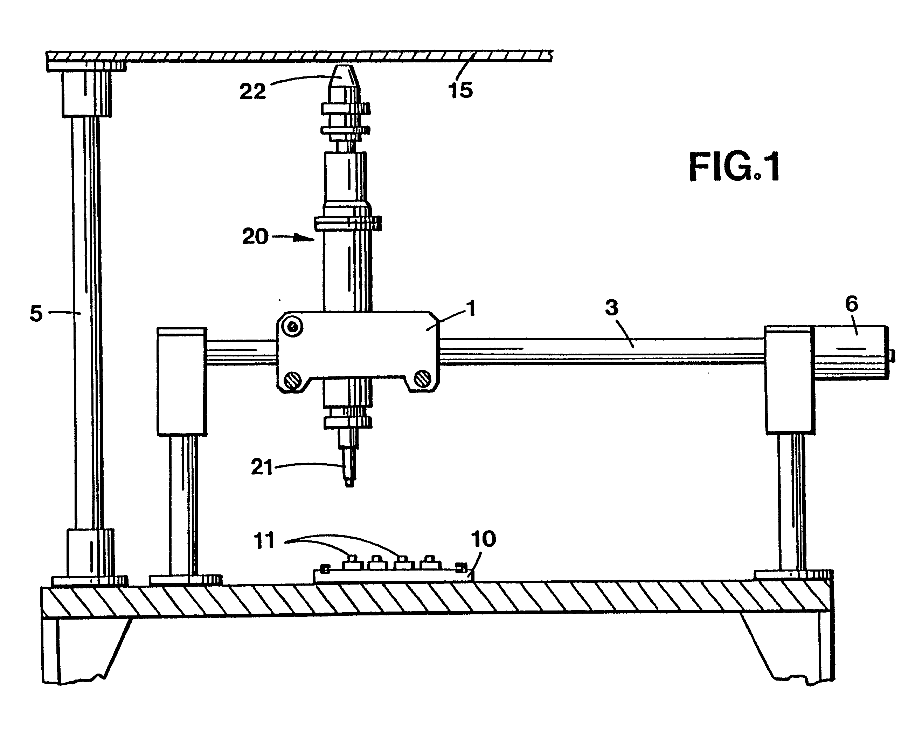

Tel que représenté dans son exécution illustrée par la figure 1, le robot selon l'invention comporte au moins un support 10 de pièces 11 dans une aire d'assemblage. Une tête 1 est mobile en translation et/ou en rotation, par exemple selon 2 ou 3 degrés de liberté, par rapport au support 10. La tête 1 se déplace sur des supports de quidage, dont un seul 3 est visible sur la figure 1, l'autre 4 étant agencé en profondeur. Un moteur 6 permet de déplacer la tête sur le support de guidage 3 visible sur la fig. 1. Un support de guidage pour un mouvement vertical de la tête est omis dans cette forme d'exécution, mais une autre forme d'exécution de l'invention peut parfaitement en être équipée.

Les divers mouvements de la tête de travail 1 sont engendrés et contrôlés à l'aide de composants usuels tels des servo-moteurs 6, entraînant des vis sans fin par exemple. La tête de travail 1 se déplace sur les supports de guidage de façon usuelle; le glissement sur les supports 3, 4 peut être assuré par exemple à l'aide de roulements conventionnels.

La commande de l'ensemble du robot peut être aussi réalisée de façon conventionnelle; elle est le plus généralement pneumatique, hydraulique ou électrique. L'ensemble du système est en outre généralement contrôlé par un ou plusieurs microprocesseurs, voire un ordinateur (non représentés).

Le robot comporte un dispositif 20 permettant d'appliquer une force mécanique au travers d'un outil 21 à une pièce 11.

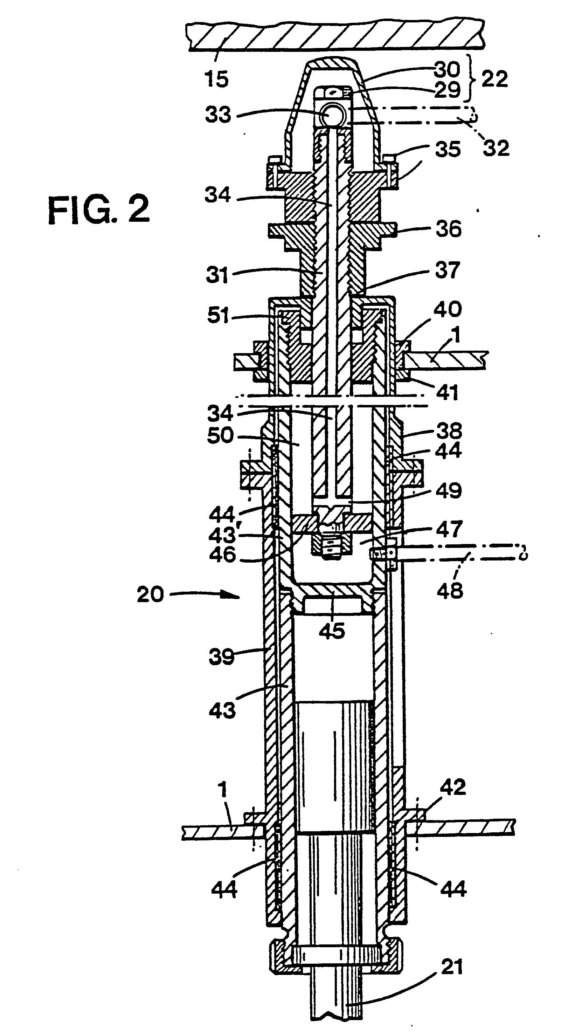

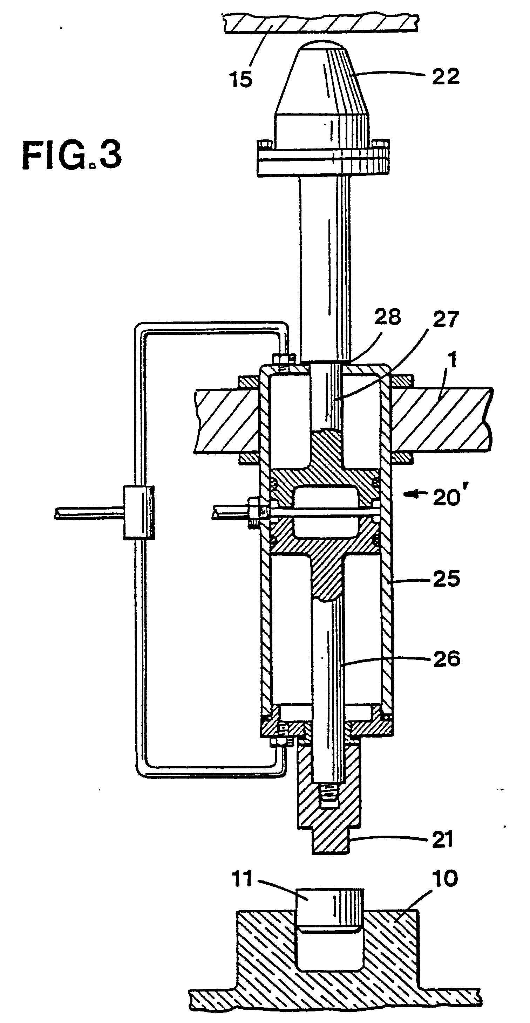

Ce dispositif peut être fixe par rapport à la tête, mais dans la forme d'exécution de la fig. 1, il est coulissant par rapport à la tête 1, et cela selon la direction de la force appliquée à la pièce. Des moyens permettant ce coulissement seront décrits ci-dessous à l'occasion de la description des fig. 2 et 3. Pour appliquer cette force à la pièce, le dispositif est équipé d'un vérin hydraulique, qui sera décrit en regard des fig. 2 et 3. Le vérin peut être commandé par des organes usuels pour développer une forme d'écartement déterminée entre ses extrémités, dont une porte l'outil 21 qui transmet la force d'application à une pièce 11 du support 10. La réaction à cette force s'exerce au travers d'une pièce d'appui 22 perpendiculairement à une plateforme 15 dont la fonction est d'absorber cette force de réaction. Dans ce but, la plateforme est reliée - au moins durant le temps d'application de la force - mécaniquement par des éléments rigides 5 au support 10 de pièces 11, pour résister à la force d'écartement créée par le vérin. On voit que lors de l'application de la force à la pièce 11, ni la force ni sa réaction s'exerçant sur la plateforme 15 ne créent une contrainte sur les supports de guidage 3, 4. Ceux-ci peuvent donc être construits de façon légère pour permettre des déplacements rapides de la tête 1 du robot, ce qui permet d'obtenir une cadence de travail élevée, qu'il serait impossible d'atteindre avec une tête et des moyens de guidage lourds capables d'absorber eux-mêmes la réaction à la force d'application à la pièce.

La tête 1 peut porter en plus du dispositif 20 un appareil de préhension (non représenté) prenant une pièce ou un composant à un endroit de l'aire de travail et le déposant à un autre endroit et/ou sur une pièce avant que le dispositif 20 ne soit engagé pour exercer sa force sur la pièce.

Une construction préférée du dispositif 20 comportant le vérin est représentée à la figure 2.

Un capuchon protecteur 30 recouvre l'extrémité supérieure 29 d'une tige de piston 31 et forme avec elle la pièce d'appui 22. Au travers dudit capuchon passe un conduit de transmission pneumatique ou hydraulique 32 aboutissant au sommet 33 d'un canal 34 percé dans l'axe de la tige 31. La position du capuchon 30 sur ladite tige 31 est assurée par le moyen d'un écrou 35 et d'un contre-écrou 36. Le contre-écrou 36 sert aussi de bague de réglage venant buter en position inférieure à la surface 37 de la partie supérieure du boîtier tubulaire 38, 39. Dans sa partie supérieure, la fixation du dispositif 20 à la tête de travail 1 est assurée à l'aide d'une bague ou plusieurs bagues 40, 41 coopérant. Dans sa partie inférieure, le dispositif coopère avec la tête 1 par l'entremise d'un épaulement 42 aménagé à la surface de la partie inférieure du boîtier 38, 39.

A l'intérieur dudit boîtier coulisse un tube intérieur 43, 43' dont le élissement peut être entre autres assuré par des paliers 44. Solidarisé à la partie inférieure dudit tube 43, 43' à l'aide de tout dispositif approprié, se trouve l'outil 21. Dans sa partie médiane, ledit tube 43, 43' comporte une paroi interne étanche 45 dont l'étanchéité et la fixation sont assurées de façon usuelle (vis, joints,...). Dans sa partie supérieure, au-dessus de ladite paroi étanche 45, ledit tube 43 comporte un piston 46 convenablement fixé à la base de la tige creuse 31 citée précédemment. C'est dans la chambre 47 ainsi aménagée qu'aboutit un second conduit de transmission pneumatique ou hydraulique 48.

Au-dessus du piston 46 aboutit le canal 34: par son ouverture 49, il est en communication avec la chambre 50. L'étanchéité de ladite chambre 50 peut être assurée dans sa partie supérieure par un écrou 51 ou tout autre dispositif analogue.

A l'exception du capuchon 30, des conduits 32 et 48 réalisés de préférence en un matériau plastique souple, les éléments constitutifs définis ci-dessus sont le plus généralement réalisés en métal. Les paliers 44, assurant le glissement du tube intérieur 43, 43', peuvent être soit en matière plastique, de préférence dure, soit en métal.

Les divers moyens annexes de commande tels que ressorts, soupapes, électro-valves par exemple, ne sont pas représentés. Ce sont des moyens connus, qui s'utilisent de façon conventionnelle.

Le fonctionnement du dispositif 20 permettant de créer une force mécanique est décrit ci-après. En un premier temps, une pression est exercée au travers du conduit 48 dans la chambre 47. Sous l'effet de ladite pression s'exerçant à la face inférieure du piston 46 solidaire de la tige 31, ladite tige subit un déplacement vertical vers le haut, tout comme les éléments 30, 35, 36 et 37 qui lui sont fixés. En fin de course ascensionnelle, l'extrémité supérieure de la tige 31 vient buter contre la plaque 15, le capuchon 30 faisant office de protection tant mécanique que phonique. Au cours de cette opération, aucune contrepression ne s'exerce dans la chambre 50. Simultanément, sous l'effet de la pression s'exerçant à la face supérieure de la paroi 45, le tube intérieur 43 porteur de l'outil 21 subit un déplacement vertical vers le bas, pour appliquer l'outil sur une pièce avec une force déterminée.

On voit que les parties actives du vérin 29, 30, 31 et 43, 43' coulissent dans le sens de la force d'écartement par rapport aux pièces 40, 42 fixant le vérin 20 à la tête 1.

Dans un second temps, une pression est exercée dans la chambre 50, au travers du conduit 32 et du canal 34, la pression première, exercée dans la chambre 47 étant simultanément relâchée, marquant ainsi la fin de la course descendante du tube 43, 43' et de son outil 21. Sous l'effet de la pression exercée à la face supérieure du piston 46, la tige 31 subit un déplacement vertical vers le bas pour revenir à sa position initiale, déterminée par la bague 36 butant sur la partie supérieure 37 du boîtier 38. Simultanément, sous l'effet de la pression s'exerçant à la face inférieure de l'écrou 51, le tube 43, 43' et son outil 21 subissent un déplacement vertical vers le haut pour retrouver également leur position initiale.

Cette succession d'opérations peut être répétée quasi indéfiniment; elle est le plus généralement commandée par le système de commande du robot.

La figure 3 représente un vérin 20' équipé de deux pistons opposés 26 et 27 dont les tiges portent respectivement la pièce d'appui 22 et l'outil 21. Le corps 25 peut maintenant être fixé de façon fixe, non coulissante à la tête 1. Les diamètres des pistons 26, 27 et de leurs chambres respectives sont égaux de sorte que les forces développées par les pistons sont égales et s'équilibrent, sans qu'une partie de la force ne s'exerce sur la tête 1.

On voit tant sur la figure 3 que sur la figure 2 une butée 28 resp. 37; celle-ci permet l'effet suivant lorsque le vérin se rétracte: dès que la pièce d'appui 22 s'est suffisamment éloignée de la plateforme 15, la butée 28 resp. 37 l'empêche d'être rétractée davantage et c'est la partie du vérin portant l'outil 21 qui est obligée de se rétracter. Ainsi l'outil s'éloigne de la pièce 11 placée sur le support 10, l'espace au-dessus de la pièce est dégagé, ce qui permet un accès facile, que ce soit pour l'inspection de la pièce ou pour son remplacement.

Dans la plupart des cas, mais ce n'est pas obligatoire, la tête 1 du robot se déplace selon des coordonnées cartésiennes et la force d'écartement agira également selon une troisième coordonnée cartésienne. La plateforme 15 étant perpendiculaire à la direction de la force d'écartement, la plateforme sera parallèle au plan de deux axes cartésiens. Souvent la plateforme 15 est montée de façon fixe.

Evidemment, dès que la force doit être appliquée à la pièce selon une autre direction, quelconque par rapport aux axes cartésiens, la réaction à la force doit être absorbée par une plateforme perpendiculaire à la direction de la force; si le travail exigé du robot d'assemblage exige plusieurs directions d'application de force, plusieurs plateformes à orientations différentes peuvent être prévues. Cette variante n'est pas représentée sur un dessin.

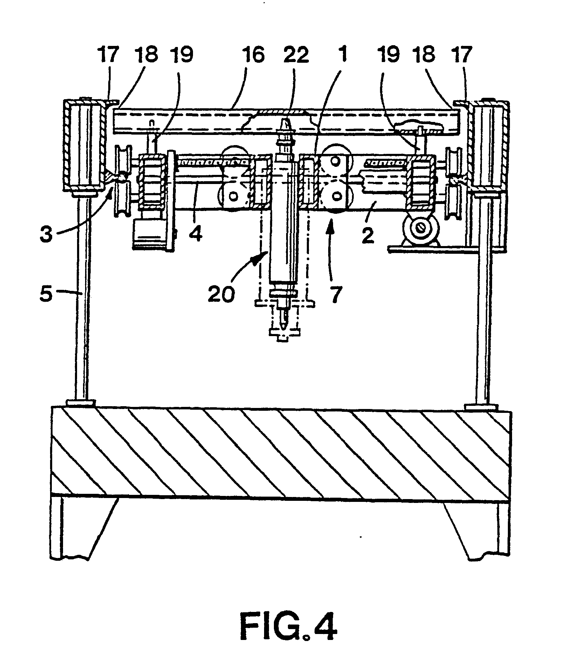

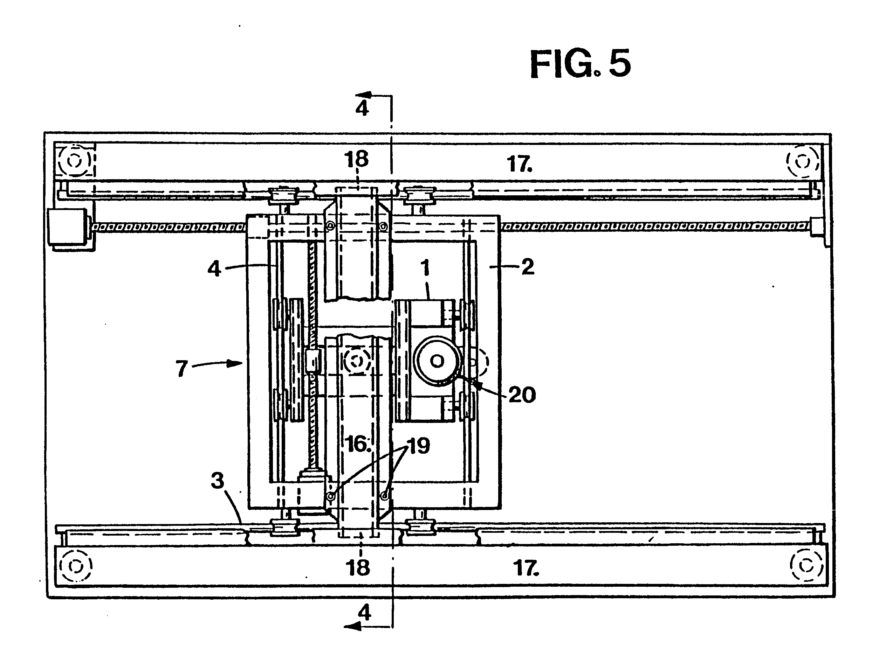

Une autre forme d'exécution de l'invention va être décrite en se référant aux figures 4 et 5, la figure 4 représente une coupe du robot selon la ligne 4-4 marquée sur la fig. 5. Pour alléger le robot, la plateforme et la structure rigide 5 qui la relie au support 10 des pièces 11, on ne prévoit pas une plateforme fixe pour toute l'aire de travail mais une plateforme 16 mobile selon une direction de translation ou de rotation. Cette plateforme mobile dans le cas d'une translation prend la forme d'une poutre mobile 16 bien visible à la figure 4. Dès que le vérin 20 exerce sa force d'écartement, la pièce d'appui 22 transmet la force de réaction à la poutre mobile 16, dont la section est en u renversé dans l'exécution de la figure 4. Les extrémités 18 de la poutre mobile 16 prennent alors appui sur les poutres fixes 17 qui résistent à la force d'écartement grâce aux éléments rigides 5 qui les relient au support 10 de pièces 11. Dès que le vérin 20 se rétracte, une fente s'établit entre les extrémités 18 de la poutre mobile et les poutres fixes; cette fente est bien visible à la figure 4; le déplacement de la poutre mobile 16 pour être maintenue face à la pièce d'appui 21 lorsque celle-ci se déplace, ne pose alors pas de problème. Pour simplifier, la poutre mobile 16 est déplacée en même temps que la tête 1 grâce à des moyens 19, par exemple tenons et trous coopérants ou bien "silent"-bloc flexible, de sorte que la poutre mobile 16 est entraînée transversalement en translation lors du déplacement de la tête sans toutefois transmettre à la tête 1 ou à ses supports de guidage 3, 4 un effort quelconque dû à la réaction à la force d'écartement.

On voit dans la forme d'exécution du robot selon les figures 4 et 5 que la tête se déplace sur un premier support de guidage 4, qui a la même direction que la poutre mobile 16. Ce premier support de guidage 4 est lui-même fixé le long d'un cadre ou chariot mobile 7 qui peut se déplacer perpendiculairement à la poutre mobile sur des seconds supports de guidage 3 fixés le long des poutres fixes 17. Pour que la poutre mobile 16 soit maintenue face à la pièce d'appui 21 du vérin 20 de la tête 1, il suffit que le cadre mobile 7 soit relié à la poutre mobile 16 par des moyens 19, de façon à lui transmettre un mouvement dans la direction des poutres fixes 17; un mouvement dans la direction de la force d'écartement ne doit pas être transmis entre la poutre mobile 16 et le cadre mobile 7, ce qui est facile à obtenir grâce à des tenons et des trous 19 orientés correctement. Des moyens de liaison 19 présentant une grande flexibilité dans la direction voulue comme des "silent" blocs peuvent aussi être utilisés.

## Revendications

1. Robot d'assemblage de pièces comprenant au moins un support (10) de pièces (11) dans une aire d'assemblage et une tête (1) portant l'outil d'assemblage (21), tête qui est mobile en translation et/ou en rotation par rapport au support de pièces grace à des supports de guidage (3, 4) et est positionnée par des moteurs (6), cette tête portant de façon fixe ou coulissante un dispositif (20) permettant d'appliquer l'outil (21) sur une pièce (11) svec une force déterminée, et au moins une plateforme (15, 16) destinée à absorber la réaction à la force exercée par le dispositif (20) à travers une pièce d'appui (22) du dispositif (20), la plateforme (15, 16) étant placée face au support (10) de pièces de façon que la tête (1) se trouve entre la plateforme (15, 16) et le support de pièces (10) et la plateforme étant reliés mécaniquement au support de pièces par des éléments rigides (5) placés hors de l'espace entre l'aire d'assemblage et la plateforme (15, 16) de façon à pouvoir résister à une force tendant à éloigner la plateforme du support, caractérisé en ce que le dispositif (20) comporte un vérin agencé pour exercer, lorsque la tête (1) est immobile, une force d'écartement entre l'outil (21) et la pièce d'appui (22), la pièce d'appui (22) étant déplaçable par rapport à la tête (1) sans l'action du vérin selon l'axe de la force d'écartement, la force étant transmise par l'outil (21) à la pièce (11) et la réaction à la force étant transmise par la pièce d'appui (22) perpendiculairement à la plateforme (15, 16), de façon que la tête (1) et ses supports de guidage (3, 4) ne sont soumis ni à la force ni à sa réaction.

2. Robot selon la revendication 1, caractérisé en ce que le vérin est un vérin alimenté par un fluide sous pression et cue le dispositif (20) avec le vérin est porté de façon coulissante par la tête (1), la direction de coulissement étant celle de la force d'écartement.

3. Robot selon la revendication 1, caractérisé en ce que le vérin est un vérin alimenté par un fluide sous pression à deux pistons opposés (20') de même section, le corps du vérin étant fixé à la tête, une tige de piston (26) portant l'outil (21), la tige de l'autre piston (27) portant la pièce d'appui (22).

4. Robot selon l'une des revendications 1 à 3, carectérisé en ce qu'une butée (28) solidaire de la pièce d'appui (22) limite la course de la pièce d'appui lorsque le dispositif se rétracte, afin que l'outil (21) dégage l'accès aux pièces (11).

5. Robot selon l'une des revendications 1 à 4, caractérisé en ce que au moins deux des supports de guidage (3, 4) de la tête (1) sont agencés selon deux axes de coordonnées cartésiens, que la plateforme (15, 16) est parallèle au plan de ces deux axes, que la tête (1) se déplace selon un des axes cartésiens sur le premier (4) desdits deux supports de guidage, qui est fixé sur un cadre mobile (7) et que le cadre mobile se déplace selon l'autre des axes cartésiens sur le second (3) desdits deux supports de guidage.

6. Robot selon l'une des revendications 1 à 4, caractérisé en ce que la plateforme (16) est fixe.

7. Robot selon l'une des revendications 1 à 6, caractérisé en ce qu'il comporte plusieurs plateformes d'orientations distinctes.

8. Robot selon l'une des revendications 1 à 5, caractérisé en ce que la plateforme (16) est mobile par rapport au support (10) des pièces (11) selon au moins une direction de translation ou de pivotement commune avec une direction de mouvement de la tête (1) et en ce que le robot comporte des moyens (19) pour déplacer ensemble la tête (5) et la plateforme (16) selon cette direction commune.

9. Robot selon la revendication 8, caractérisé en ce que la plateforme est constituée par une poutre (16) mobile transversalement en translation, en ce que deux poutres fixes (17) sont reliées au support (10) des pièces (11) par les éléments rigides (5) placés hors de l'espace entre l'aire d'assemblage et la plateforme (16) et sont disposées perpendiculairement à la poutre mobile (18), de façon que chaque extrémité (16) de la poutre mobile (16) vienne s'appuyer sur une poutre fixe lorsque la force est appliquée par l'outil (21) sur la pièce (11) et que la force da réaction se transmet par la pièce d'appui (22) à la poutre mobile (16), et de façon que, lorsque la force n'est pas appliquée à l'outil, les extrémités (18) de la poutre mobile (16) sont séparées des poutres fixes (17) par une fente permettant à des moyens d'entraînement de déplacer la poutre mobile transversalement et de la maintenir face à la pièce d'appui (22).

10. Robot selon les revendications 5, 8 et 9, caractérisé en ce que les poutres fixes (17) sont parallèles au second support de guidage (3) sur lequel le cadre mobile (7) se déplace et en ce que des moyens coopérants (19) placés sur le cadre mobile (7) et la poutre mobile (16) sont agencés de façon à entraîner depuis le cadre mobile (7) la poutre mobile (16) en déplacement transversal sans que la réaction à la force appliquée à la pièce (11) ne soit transmise par la poutre mobile (16) au cadre mobile (7).

**Patentansprüche**

1. Montage-Roboter zum Zusammensetzen von Werkstücken mit mindestens einem Träger (10) für die Werkstücke (11) in einem Montagebereich und einem Kopf (1), der ein Montagewerkzeug (21) trägt, das gegenüber dem Werkstück-Träger an Führungsträgern (3, 4) verschiebbar und/oder drehbar angeordnet ist und von Motoren (6) positioniert wird, wobei dieser Kopf eine feste oder verschiebbare Vorrichtung (20) zum Halten von Werkzeugen aufweist, welche es erlaubt, ein Werkzeug mit einer vorgegebenen Kraft auf ein Werkstück anzuwenden, und mit mindestens einer Abstützung (15, 16) zum Aufnehmen der Reaktionskräfte, welche durch die von der Vorrichtung (20) zum Halten der Werkzeuge über einen Abstützteil (22) der Vorrichtung (20) ausgeübten Kräfte entstehen, wobei die Abstützung (15, 16) gegenüber dem Träger (10) für die Werkstücke (11) derart angeordnet ist, dass der Ropf (1) sich zwischen der Abstützung (15, 16) und dem Werkstückträger (10) befindet und die abstützung (15, 16) mit dem Werkstückträger (10) mechanisch mit starren Elementen (5), derart verbunden ist, dass sie eine Kraft, welche Abstützung und Führungsträger voneinander drängt aufnehmen können, dadurch gekennzeichnet, dass der Abstützteil (22), der gegenüber dem Kopf (1) bei Betätigung des Hebers in Richtung der Kraft verschiebbar ist, einen Teleskopheber umfasst, der, während der Kopf (1) unbeweglich ist, eine Trennkraft zwischen Werkzeug (21) und Abstützteil (22) ausübt, wobei die Kraft vom Werkzeug (21) auf das Werkstück (11) und die Reaktionskraft über den Abstützteil derart senkrecht auf die Abstützung (15, 16) übertragen werden, dass der Kopf (1) und seine Führungsträger (3, 4) weder von der Kraft selbst, noch von ihrer Reaktionskraft beansprucht sind.

2. Roboter nach Anspruch 1, dadurch gekennzeichnet, dass der Heber von einem fluidischen Druckmedium angetrieben wird und die Vorrichtung (20) mit dem Heber auf dem Kopf (1) gleitend verschiebbar angebracht ist und die Verschiebung in Richtung der trennenden Kraft erfolgt.

3. Roboter nach Anspruch 1, dadurch gekennzeichnet, dass der Heber über zwei gegenüberliegende Kolben (20') mit gleichem Querschnitt druckfluidbetätigt ist, dass das Gehäuse des Hebers am Kopf befestigt ist, dass die Stange des einen Kolbens (26) das Werkzeug (21) und die Stange des andern Kolbens (27) das Abstützelement (22) trägt.

4. Roboter nach einem der Ansprüche 1 bis 3, dadurch gekennzeichnet, dass das Abstützelement (22) einen Anschlag (28) aufweist, der den Weg des Abstützelementes beim Zurückziehen begrenzt, sodass das Werkzeug den Zugang zu dem Werkstücken (11) freigibt.

5. Roboter nach einem der Ansprüche 1 bis 4, dadurch gekennzeichnet, dass wenigstens zwei Führungsträger (3, 4) des Kopfes (1) in der Richtung von zwei Achsen eines kartesischen Koordinatensystems angeordnet sind, dass die Abstützung (15, 16) zur Ebene dieser beiden Achsen parallel ist, dass der Kopf (1) sich nach einer der kartesischen Achsen auf dem einen der beiden Führungsträger (4) bewegt, welcher auf einem beweglichen Rahmen (7) befestigt ist, und dass der bewegliche Rahmen sich auf dem zweiten (3) der genannten Führungsträger in Richtung der andern kartesischen Achse bewegt.

6. Roboter nach einem der Ansprüche 1 bis 4, dadurch gekennzeichnet, dass die Abstützung (16) feststehend ist.

7. Roboter nach einem der Ansprüche 1 bis 6, dadurch gekennzeichnet, dass er mehrere, in einer bestimmten Richtung orientierte Abstützungen aufweist.

8. Roboter nach einem der Ansprüche 1 bis 5, dadurch gekennzeichnet, dass die Abstützung (16) gegenüber dem Träger (10) für die Werkstücke (11) wenigstens in einer translatorischen Richtung oder in einer Drehrichtung bewegbar ist, wobei diese Richtung eine Bewegungrichtung des Kopfes (1) ist, und dass der Roboter Mittel (19) zum gemeinsamen Verschieben von Kopf (5) und Abstützung (16) in dieser Richtung aufweist.

9. Roboter nach Anspruch 8, dadurch gekennzeichnet, dass die Abstützung ein quer verschiebbarer Träger (16) ist, dass zwei feststehende Träger (17) mit dem Träger (10) für die Werkstücke (11) durch starre Elemente (5) verbunden sind, welche sich ausserhalb des Raumes zwischen Montagebereich und Abstützung (16) befinden und welche derart senkrecht zum verschiebbaren Träger (16) angeordnet sind, dass jedes Ende (18) des verschiebbaren Trägers (16) auf einem feststehenden Träger (17) abgestützt ist, venn die Kraft auf das Werkzeug (21) wirkt und zwar derart, dass die Enden (18) des verschiebbaren Trägers (16) von den feststehenden Trägern (17) durch eine Spalt getrennt sind, wenn keine Kraft auf das Werkzeug angewendet wird, sodass der verschiebbare Träger durch Anriebsmittel quer verschoben werden und dem Abstützteil (22) gegenüberliegend angeordnet werden kann.

10. Roboter nach den Ansprüchen 5, 8 und 9, dadurch gekennzeichnet, dass die feststehenden Träger (17) parallel zum zweiten Rahmenträger (3) angeordnet sind, auf velchem der bewegbare Rahmen (7) sich bewegt, indem zusammenwirkende Mittel (19) auf dem bewegbaren Rahmen (7) und dem bevegbaren Träger (16) derart angeordnet sind, dass die Querverschiebung erfolgen kann, ohne dass eine Beeinflussung durch die auf das Werkstück (11) ausgeübte Rraft, über den beweglichen Träger (16), auf den verschiebbaren Rahmen (7) erfolgt.

**Claims**

1. A robot for assembling components, comprising at least one support (10) for components (11) in an assembly area, a head (1) carrying the assembly tool (21), which head can undergo translational and/or rotational motion relative to the component support by virtue of guide supports (3, 4) and is positioned by motors (6), this head carrying a device (20) in a fixed or sliding manner, making it possible to apply the tool (21) to a component (11) with a given force, and at least one platform (15, 16) for absorbing the reaction to the force exerted by the device (20) through a bearing part (22) belonging to the device (20), the platform (15, 16) being located opposite the component support (10) so that the head (1) is between the platform (15, 16) and the component support (10), and the platform being mechanically joined to the component support by rigid elements (5) located outside the space between the assembly area and the platform (15, 16) so as to be able to withstand a force tending to separate the platform from the support, characterized in that the device (20) includes a cylinder arranged so that, when the head (1) is immobile, it exerts a separating force between the tool (21) and the bearing part (22), the bearing part (22) being displaceable relative to the head (1) under the action of the cylinder along the axis of the separating force, the force being transmitted by the tool (21) to the component (11) and the reaction to the force being transmitted by the bearing part (22) in a direction perpendicular to the platform (15, 16), so that the head (1) and its guide supports (3, 4) are not subjected to the force or to its reaction.

2. The robot according to Claim 1, characterized in that the cylinder is a cylinder driven by a pressurized fluid and that the device (20), with the cylinder, is carried by the head (1) in a sliding manner, the direction of sliding being that of the separating force.

3. The robot according to Claim 1, characterized in that the cylinder is a cylinder driven by a pressurized fluid with two opposing pistons (20') of the same crosssection, the body of the cylinder being fixed to the head, one piston rod (26) carrying the tool (21) and the other piston rod (27) carrying the bearing part (22).

4. The robot according to one of Claims 1 to 3, characterized in that a stop (28) integral with the bearing part (22) limits the travel of the bearing part when the device retracts, so that the tool (21) clears access to the components (11).

5. The robot according to one of Claims 1 to 4, characterized in that at least two of the guide supports (3, 4) associated with the head (1) are arranged along two cartesian coordinate axes, in that the platform (15, 16) is parallel to the plane of these two axes, in that the head (1) moves along one of the cartesian axes on the first (4) of the said two guide supports, which is fixed to a mobile frame (7), and in that the mobile frame moves along the other of the cartesian axes on the second (3) of the said two guide supports.

6. The robot according to one of Claims 1 to 4, characterized in that the platform (16) is fixed.

7. The robot according to one of Claims 1 to 6, characterized in that it includes several platforms with different orientations.

8. The robot according to one of Claims 1 to 5, characterized in that the platform (16) can move relative to the support (10) for the components (11) in at least one translational or pivoting direction in common with a direction of movement of the head (1), and in that the robot includes means (19) for displacing the head (1) together with the platform (16) in this common direction.

9. The robot according to Claim 8, characterized in that the platform consists of a beam (16) which can undergo translational motion transversely, and in that two fixed beams (17) are joined to the support (10) for the components (11) by the rigid elements (5) located outside the space between the assembly area and the platform (16) and are arranged perpendicular to the mobile beam (16), so that each end (18) of the mobile beam (16) comes to bear against a fixed beam when the force is applied by the tool (21) to the component (11) and then the reaction force is transmitted by the bearing part (22) to the mobile beam (16), and so that, when the force is not applied to the tool, the ends (18) of the mobile beam (16) are separated from the fixed beams (17) by a slot enabling driving means to move the mobile beam transversely and keep it opposite the bearing part (22).

10. The robot according to Claims 5, 8 and 9, characterized in that the fixed beams (17) are parallel to the second guide support (3) on which the mobile frame (7) moves, and in that interacting means (19), located on the mobile frame (7) and the mobile beam (16), are arranged so as to drive the mobile beam (16) transversely from the mobile frame (7) without the reaction to the force applied to the component (11) being transmitted by the mobile beam (16) to the mobile frame (7).

FIG.1

FIG. 2

0 155 278

FIG.3

FIG.4

FIG. 5